(19) Europäisches Patentamt
European Patent Office
Office européen des brevets

(11) Veröffentlichungsnummer: **0 410 256 A1**

# (12) EUROPÄISCHE PATENTANMELDUNG

(21) Anmeldenummer: **90113581.4**

(51) Int. Cl.5: **G03F 7/004**

(22) Anmeldetag: **16.07.90**

(30) Priorität: **26.07.89 DE 3924784**

(43) Veröffentlichungstag der Anmeldung: **30.01.91 Patentblatt 91/05**

(84) Benannte Vertragsstaaten: **BE CH DE FR GB IT LI NL**

(71) Anmelder: **Siemens Aktiengesellschaft**
**Wittelsbacherplatz 2**
**D-8000 München 2(DE)**

(72) Erfinder: **Sebald, Michael, Dr.**
**Kirchensteig 3**
**D-8521 Hessdorf-Hannnberg(DE)**
Erfinder: **Beck, Jürgen**
**Täublingstrasse 30**
**D-8520 Erlangen(DE)**
Erfinder: **Leuschner, Rainer, Dr.**
**Buchenweg 2**
**D-8521 Grossenseebach(DE)**
Erfinder: **Sezi, Recai, Dr.**
**Weiherstrasse 14**
**D-8551 Röttenbach(DE)**
Erfinder: **Bestmann, Hans Jürgen, Prof. Dr.**
**Spitzwegstrasse 31**
**D-8520 Erlangen(DE)**

## (54) Lichtempfindliches Gemisch.

(57) Lichtempfindliche Gemische aus einem Polymeren und einer photoaktiven Komponente, die wäßrig-alkalisch entwickelbar sind, zeigen dann ein gutes Ausbleichverhalten im DUV-Bereich, wobei die photoaktive Komponente gute Lösungsinhibitoreigenschaften aufweist und sich während des Trocknungsprozesses nicht verflüchtigt, wenn die photoaktive Komponente Diazotetronsäure oder ein Diazotetronsäurederivat folgender Struktur ist:

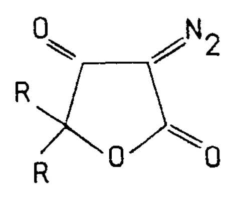

,

wobei die Reste R gleich oder verschieden sind und H, Alkyl, Cycloalkyl, Aryl oder einen siliciumhaltigen Rest bedeuten.

EP 0 410 256 A1

# LICHTEMPFINDLICHES GEMISCH

Die Erfindung betrifft ein lichtempfindliches Gemisch aus einem Polymeren und einer photoaktiven Komponente sowie ein Verfahren zur Herstellung von Reliefstrukturen aus einem derartigen lichtempfindlichen Gemisch.

Photolithographisch aus lichtempfindlichen Gemischen, d.h. Photoresists, erzeugte Strukturen im µm- und sub-µm-Bereich spielen bei der Herstellung hochintegrierter Schaltkreise eine Schlüsselrolle. Derartige Strukturen dienen nämlich generell als Masken bei einer Reihe von Prozeßschritten, die bei der Herstellung dieser Bauelemente durchlaufen werden, wie Ionenimplantation, Dotierung, Naß- und Trockenätzen.

Während die thermischen und mechanischen Eigenschaften der Reliefstrukturen sowie die Ätzresistenz durch die Auswahl der Harzbasis, d.h. des Polymeren, des zugrundeliegenden Resists beeinflußt werden können, wird die Photostrukturierbarkeit überwiegend von der photoaktiven Komponente bestimmt. Photoaktive Komponente und Polymeres müssen dabei allerdings soweit zusammenpassen, daß beispielsweise keine Entmischung des lichtempfindlichen Gemisches erfolgt und der belichtete Resist entwickelt werden kann. Die photoaktive Komponente muß darüber hinaus eine Reihe von Anforderungen erfüllen, wie gute Löslichkeit, Lagerbeständigkeit, Entwickelbarkeit mit ungiftigen, möglichst wäßrigen, d.h. ökologisch unbedenklichen Entwicklern, und hohe Empfindlichkeit, d.h. kurze Belichtungszeit, verbunden mit einem Bleichen der photoaktiven Komponente. Außerdem darf die Haftung des Polymeren auf dem Substrat nicht beeinträchtigt werden und es muß eine genaue Übertragung der Vorlage gewährleistet sein, verbunden mit einer guten Auflösung.

Zur Erzeugung feiner Strukturen können entweder Negativresists oder Positivresists verwendet werden (siehe beispielsweise: "Angew. Chem.", Bd. 94 (1982), Seiten 471 bis 485). Negativresists, bei denen das Strukturierungsprinzip im allgemeinen auf einer Vernetzung der belichteten Teile beruht, womit eine Erniedrigung der Löslichkeit verbunden ist, zeigen im Vergleich zu Positivresists eine geringere Auflösung, bedingt durch Quellung, und werden meist mit - ökologisch und wirtschaftlich ungünstigen - organischen Entwicklern entwickelt. Bei Positivresists, bei denen die Löslichkeit im Entwickler durch die Strahlungseinwirkung erhöht wird, wird der Löslichkeitsunterschied zwischen den belichteten und den unbelichteten Teilen meist durch eine photochemisch induzierte Änderung der Polarität bewirkt, wodurch - ohne Quellung - eine wäßrig-alkalische Entwicklung ermöglicht wird.

Kommerziell vertriebene Positivresists basieren im allgemeinen auf Novolakharzen als alkalilösliches Basispolymer und Sulfonsäureestern von Diazonaphthochinonen als photoaktive Komponente (a.a.O., Seite 481); derartige Resists erfüllen die Anforderung hinsichtlich eines guten Bleichverhaltens, einer hohen Empfindlichkeit und einer hohen Auflösung bis in den Halbmikronbereich bei Belichtung im nahen UV, d.h. beispielsweise bei Belichtungswellenlängen von 436 bzw. 365 nm. Im Zuge der steigenden Integrationsdichte bei elektronischen Bauelementen wird aber eine Auflösung im sub-µm-Bereich gefordert. Diese Höchstauflösung kann nach der Formel $CD = k \frac{\lambda}{NA}$ , wobei CD die kleinste abgebildete Struktur, $\lambda$ die Wellenlänge des zum lithographischen Prozeß benutzten Lichtes, NA die vom optischen System abhängige numerische Apertur und k ein prozeßspezifischer Faktor ist, durch Reduzierung der Belichtungswellenlänge, beispielsweise auf 248 nm (DUV, KrF-Excimerlaser), realisiert werden. Die vorstehend genannten kommerziellen Resistsysteme können jedoch - aufgrund des ungenügenden Bleichverhaltens der photoaktiven Komponenten und der hohen Absorption der Novolak- Basisharze - bei dieser Wellenlänge nicht eingesetzt werden; sie weisen nämlich Restabsorptionen $> 0{,}3\ \mu m^{-1}$ auf, während Restabsorptionen < als $0{,}1\ \mu m^{-1}$ erforderlich sind. Zur Realisierung höchstauflösender, positiv arbeitender DUV-Resists (DUV = Deep UV), insbesondere für eine Belichtung bei 248 nm, sind somit geeignete DUV-transparente Basispolymere und vollständig bleichende photoaktive Komponenten mit dem vorstehend genannten Anforderungsprofil erforderlich.

Als photoaktive Komponente (PAC) für positive DUV-Photoresists wurden bereits verschiedene 2-Diazo-1.3-diketone vorgeschlagen, die - analog zu den Diazonaphthochinonen für den NUV-Bereich (NUV = Near UV) - bei DUV-Belichtung, via Wolff-Umlagerung und Reaktion des dabei gebildeten Ketens mit Wasser, zu den entsprechenden Carbonsäuren derivatisieren und den Resist somit in den belichteten Bereichen alkalisch entwickelbar machen. So ist die Verwendung von Diazomeldrumsäure (2.2-Dimethyl-5-diazo-1.3dioxan-4.6-dion) und Derivaten davon als PAC in Abmischungen mit Novolaken als DUV-Resist beschrieben (siehe dazu: US-PS 4 339 522 sowie "IEEE Trans. Electron Devices", Vol. ED-28 (1981), Seiten 1300 bis 1305, und "J. Vac. Sci. Technol. B", Vol. 6 (1988), Seiten 559 bis 563). Obwohl diese Verbindungen im DUV-Bereich ein sehr gutes Ausbleichverhalten zeigen, verbunden mit hohem Kontrast und relativ hoher Empfindlichkeit (50 $mJ/cm^2$), ist die Auflösung - aufgrund der Verflüchtigung der Diazomeldrumsäure aus der Resistschicht während des Trocknungsprozesses und der schlechten Lösungsinhibitoreigenschaft

dieser Verbindung - auf ca. 2 µm begrenzt. Außerdem konnten keine nichtflüchtigen Derivate der Diazomeldrumsäure mit ausreichender Löslichkeit in üblichen Resistlösungsmitteln aufgefunden werden.

Aus den US-Patentschriften 4 622 283 und 4 624 908 ist es bekannt, Diazodimedon (2-Diazo-5.5-dimethyl-cyclohexan-1.3-dion) bzw. Derivate davon und andere 2-Diazo-1.3-diketone, wie Diazo cyclopentandion, als DUV-PAC in Abmischungen mit Novolaken, Polyvinylphenol und Methacrylat/Methacrylsäure-Copolymeren zu verwenden (siehe dazu auch: "Proc. of SPIE", Vol. 920 (1988), Seiten 51 bis 58). Die Diazodimedonderivate verflüchtigen sich zwar - im Gegensatz zur Diazomeldrumsäure und auch zum Diazodimedon selbst - während des Trocknungsprozesses nicht und sind in Resistlösungsmitteln löslich, und sie zeigen auch, ebenso wie Diazodimedon und Diazomeldrumsäure, ein ausgezeichnetes Ausbleichverhalten im DUV-Bereich, mit ihnen läßt sich aber -aufgrund der hohen Dunkelabtragsraten der gewählten Resistsysteme (14 bis 42 % der ursprünglichen Filmdicke) - lediglich eine Auflösung von 0,75 µm bei gleichzeitig schrägen Strukturflanken erzielen. Diese Resistsysteme sind außerdem relativ unempfindlich (100 bis 150 $mJ/cm^2$).

Weitere nichtflüchtige Diazoketone mit gutem DUV-Ausbleichverhalten sind Diazotetramsäure (3-Diazo-pyrrolidin-2.4-dion) und Diazohomotetramsäure (3-Diazo-piperidin-2.4-dion) sowie 1.2-Diphenyl-4-diazo-pyrazolidin-3.5-dion (siehe dazu: "Proc. of SPIE", Vol. 771 (1987), Seiten 2 bis 10). Diese Verbindungen dienen als DUV-PAC in Resistformulierungen mit Novolak, Styrol/Maleinimid-Copclymeren, Polyglutarimid und Polyvinylphenol. Auch mit diesen Systemen werden aber - aufgrund des geringen Kontrastes - lediglich Strukturen mit sehr schrägen Flanken erhalten, die allenfalls in einem Dreilagensystem Verwendung finden können, für die Sub-Halbmikron-Lithographie jedoch untauglich sind. So werden nach einer DUV-Breitbandbelichtung 1 µmSteg/Graben-Strukturen mit sehr schrägen Flanken erhalten und nach einer KrF-Excimerlaser-Belichtung stark überbelichtete 1,5 µm-Steg/Graben-Strukturen mit etwas steileren Flanken.

Es wurde ferner bereits über ein System aus einem Chlorsulfonylphenyl-diazocycloheptandion-Derivat als PAC und Styrol/Maleinsäurehalbester-Copolymer als Basisharz berichtet ("SPIE's 1989 Symposium on Microlithography", 26. Februar bis 3. März 1989, San Jose, Kalifornien USA: Tagungsband, Seite 34). Dieses System dürfte aber, sowohl aufgrund der Korrosivität der Chlorsulfonylgruppen als auch der damit verbundenen Lagerinstabilität bei der Einwirkung von Luftfeuchte, keine Verwendung in der höchstauflösenden Siliciumtechnologie finden.

Aufgabe der Erfindung ist es, wäßrig-alkalisch entwickelbare, positiv arbeitende DUV-Photoresists, insbesondere für eine KrF-Excimerlaser-Belichtung bei 248 nm, in Form von lichtempfindlichen Gemischen aus einem Polymeren und einer photoaktiven Komponente anzugeben, deren photoaktive Komponente sowohl ein gutes Ausbleichverhalten im DUV-Bereich, verbunden mit guten Lösungsinhibitoreigenschaften, besitzt als auch sich während des Trocknungsprozesses nicht aus der Resistschicht verflüchtigt.

Dies wird erfindungsgemäß dadurch erreicht, daß die photoaktive Komponente Diazotetronsäure oder ein Diazotetronsäurederivat folgender Struktur ist:

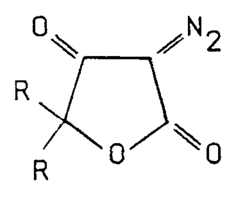

(I),

wobei die Reste R gleich oder verschieden sind und folgende Bedeutung haben:

R = H, Alkyl, vorzugsweise mit 1 bis 5 C-Atomen, Cycloalkyl, Aryl oder ein siliciumhaltiger Rest,

oder zumindest einer der Reste R eine aliphatische oder aromatische Gruppe ist, die wenigstens eine weitere Diazotetronsäuregruppierung trägt,

oder einer der Reste R für eine Einfachbindung steht, durch die die Diazotetronsäuregruppierung direkt an das Polymer gebunden ist,

oder einer der Reste R ein Alkylen-, Arylen- oder zweibindiger siliciumhaltiger Rest ist, der an das Polymer gebunden ist.

Der Photoresist nach der Erfindung enthält als PAC 3-Diazotetronsäure bzw. in 5-Stellung substituierte Derivate dieser Verbindung (Tetronsäure ist 2.4(3H.5H)-Furandion); dabei können auch Gemische dieser Verbindungen eingesetzt werden. Derartige photoaktive Komponenten weisen ein hervorragendes Ausbleichverhalten im DUV-Bereich auf und ermöglichen somit - in Abmischung mit DUV-transparenten Basispolymeren - eine Ausschöpfung der DUV-Belichtungsanlage, beispielsweise eines KrF-Excimerlaser-Steppers, bis an die Grenzen. Die Restabsorption der erfindungsgemäßen lichtempfindlichen Gemische, d.h. der DUV-Resists, nach der Belichtung liegt dabei im Bereich von 0,08 bis 0,06 $µm^{-1}$ und erlaubt es

dem einfallenden Licht somit, auch die tiefer liegenden Bereiche der Resistschicht ungemindert zu erreichen. Diese Eigenschaft macht sich in einem hohen Kontrast dieser Resists und in einer hohen Flankensteilheit der daraus erzeugten Resiststrukturen bemerkbar.

Ein weiterer Vorteil von photoaktiven Komponenten der genannten Art liegt in deren ausgezeichneten Lösungsinhibitoreigenschaften und in der schnellen und vollständigen photochemischen Umwandlung in hydrophile Carbonsäureverbindungen (Grundkörper: Oxetan-2-on-3-carbonsäure) bei der Belichtung:

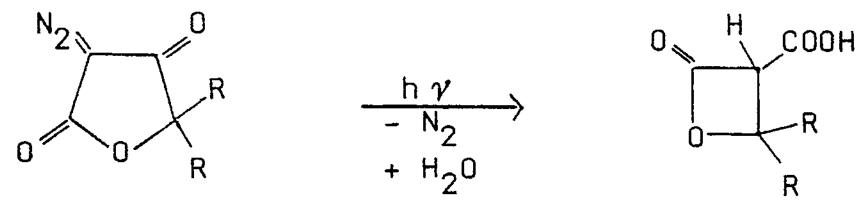


.

So ist es auch zu erklären, daß unbelichtete Resistschichten aus den erfindungsgemäßen lichtempfindlichen Gemischen bei der wäßrig-alkalischen Entwicklung so gut wie keinen Dunkelabtrag aufweisen, während die belichteten Stellen - bei einer hohen Empfindlichkeit - schnell entwickelt werden. Hochempfindliche che Resists erfordern zur Strukturierung nur eine geringe Lichtdosis, d.h. eine kurze Belichtungszeit, und ermöglichen somit eine Reduzierung der Belegungszeiten auf den kostenintensiven Belichtungsapparaturen.

Weitere Vorteile der Diazotetronsäure und ihrer Derivate bei der Verwendung als photoaktive Komponente ,sind die gute Löslichkeit in den üblichen Resistlösungsmitteln, die gute Verträglichkeit mit den Basispolymeren und die gute Lagerstabilität in den Resistabmischungen. Diese Verbindungen zeichnen sich ferner durch eine hohe Temperaturstabilität (> 120 °C) und durch Nichtflüchtigkeit während des Resisttrocknungsprozesses aus. Somit ist auch bei Schwankungen der Trocknungsbedingungen, wie Temperatur und Druck, eine hohe lithographische Reproduzierbarkeit gewährleistet.

Die Auswahl der geeigneten photoaktiven Komponenten unterliegt grundsätzlich keinen Beschränkungen, da sich die genannten Vorteile prinzipiell aus der Struktur der Diazotetronsäure ergeben. Die Reste R (siehe Formel I) können deshalb aliphatischer und/oder aromatischer Natur sein und sie können auch ätzresistente Elemente enthalten, insbesondere Silicium für eine erhöhte Ätzresistenz im Sauerstoffplasma. Die photoaktive Komponente wird aber auf das jeweilige Basispolymer abgestimmt.

Als Basispolymer finden in den erfindungsgemäßen lichtempfindlichen Gemischen vorzugsweise Polymere mit Carbonsäureanhydridgruppen Verwendung; daneben kommen aber auch andere DUV-transparente Polymere, wie Polyvinylphenol, Styrol/Maleinimid-Copolymere und Polyglutarimid, in Betracht. Die DUV-transparenten anhydridhaltigen Polymeren weisen vorteilhaft folgende Struktur auf:

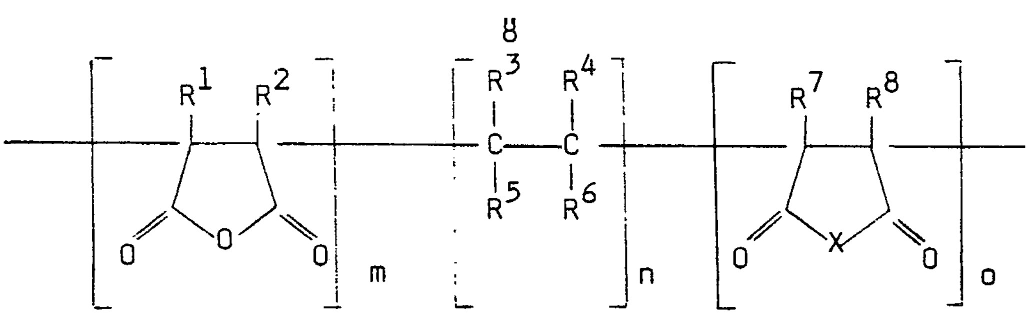

,

wobei m, n und o ganze Zahlen bedeuten und n und/oder o den Wert 0 annehmen kann und das Strukturfragment mit dem Index m einen Anteil von 10 bis 55 % an der Gesamtstruktur ausmacht, X = O, S oder NR′ ist, wobei R′ für H, Alkyl, Vinyl, Allyl, Acryl oder Aryl steht, und die Reste $R^1$ bis $R^8$ Wasserstoff, Alkyl, Aryl, Halogen, halogensubstituiertes Alkyl bzw. Aryl oder einen olefinisch ungesättigten Rest bedeuten und einer der Reste $R^3$ bis $R^6$ außerdem folgende Bedeutung haben kann:

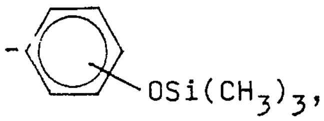, 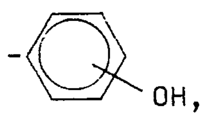, 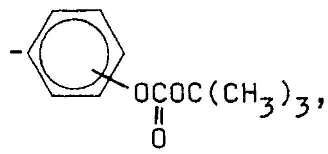, 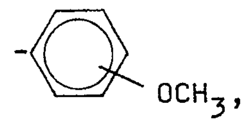,

-COOH, -COOR, $CH_2Si(CH_3)_3$, $-Si(CH_3)_3$ und $Si(OCH_3)_3$ .

Als regelmäßig wiederkehrende Einheiten kann das Basispolymer in der Kette außerdem Fragmente folgender Struktur aufweisen:

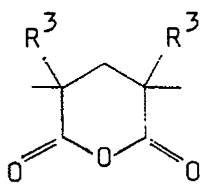 , 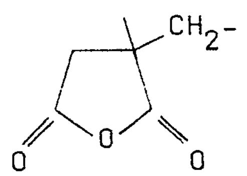 und 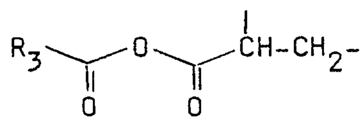 ,

wobei $R^3$ für die bereits angegebenen Gruppen steht. Desweiteren kann das Basispolymer von Anhydridmonomeren abgeleitet sein, die zumindest eine der folgenden Strukturen aufweisen:

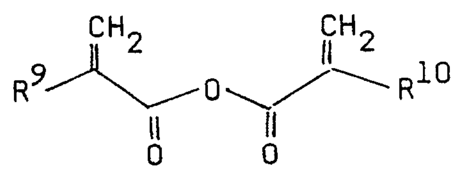 , 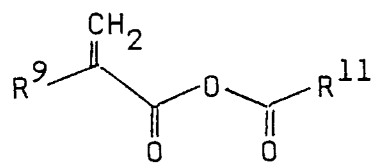 ,

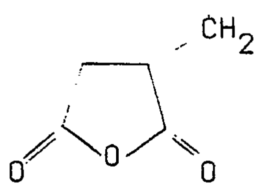 und 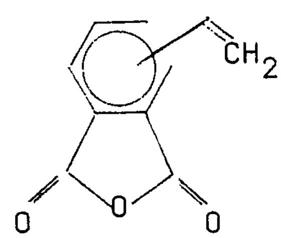 .

wobei $R^9$ und $R^{10}$ H oder Alkyl bedeuten und $R^{11}$ für einen Alkyl-oder Arylrest steht.

Das lichtempfindliche Gemisch nach der Erfindung enthält vorzugsweise 1 bis 50 Masse-% an photoaktiver Komponente auf der Basis von Diazotetronsäure; vorteilhaft beträgt der Gehalt an PAC 15 bis 25 Masse-%. Für den Fall, daß die Diazotetronsäuregruppierung an das Polymer gebunden ist, und zwar unmittelbar oder über eine Brücke, kann dieses Polymer gleichzeitig als Basispolymer und als PAC fungieren, wodurch sich die Beimischung einer weiteren photoaktiven Komponente erübrigen kann.

Ein weiterer Vorteil der erfindungsgemäßen photoaktiven Komponente liegt in der leichten Zugänglichkeit. Die Herstellung erfolgt nämlich durch einfaches Diazotieren von Tetronsäure oder einem ihrer Derivate, beispielsweise mittels Tosylazid. Die Synthese von Tetronsäure selbst bzw. von Tetronsäurederivaten ist in der Literatur beschrieben (siehe dazu beispielsweise: "Syn. Commun.", Vol. 11 (1981), Seiten 385 bis 390, bzw. "Spectrochim. Acta", Vol. 40A (1984), Seiten 1007 bis 1009).

Zur Herstellung von Reliefstrukturen wird ein lichtempfindliches Gemisch nach der Erfindung in Form einer Schicht oder Folie auf ein Substrat aufgebracht und mit aktinischem Licht durch eine Maske belichtet oder durch Führen eines entsprechenden Lichtstrahls bestrahlt. Anschließend werden die belichteten bzw. bestrahlten Schicht- oder Folienteile herausgelöst oder abgezogen, und die dabei erhaltenen Strukturen werden dann bei erhöhter Temperatur getrocknet und gegebenenfalls getempert.

Das lichtempfindliche Gemisch, d.h. der Photoresist, kann vorteilhaft als Lösung in einem organischen Lösungsmittel auf das Substrat aufgebracht werden. Als Lösungsmittel wird dabei vorzugsweise Methoxypropylacetat oder N-Methylpyrrolidon verwendet. Daneben können aber auch andere organische Lösungsmittel mit ähnlichen Eigenschaften zum Einsatz gelangen, wie Ethoxyethylacetat, Butylacetat und Cyclohexanon, sowie Gemische der genannten Lösungsmittel.

Beim erfindungsgemäßen Verfahren kann vorteilhaft ein Haftmittel und/oder ein Benetzungsmittel verwendet werden. Haft- bzw. Vernetzungsmittel können dabei der Photoresistlösung zugesetzt werden, sie können aber auch - vor der Beschichtung mit dem Photoresist - auf das Substrat aufgebracht werden. Die Photoresistlösung wird vorzugsweise mittels Schleuder- oder elektrostatischer Sprühtechnik auf das Substrat aufgebracht. Daneben können aber auch andere Beschichtungsmethoden, wie Tauchen, Bürsten und Rollen, angewendet werden. Das Substrat besteht vorzugsweise aus Glas, aus Metall, insbesondere Aluminium, aus Kunststoff oder aus einem halbleitenden Material.

Anhand von Ausführungsbeispielen soll die Erfindung noch näher erläutert werden.

1. Herstellung von Diazotetronsäure

15 g Tetronsäure werden in 150 ml Ethanol vorgelegt und unter Eiskühlung mit 15,2 g Triethylamin versetzt. Das Gemisch wird auf -10 °C abgekühlt, dann wird eine äquimolare Menge an Tosylazid zugegeben. Anschließend wird das Gemisch 1 h im Kältebad gerührt und dann 24 h im Kühlfach gelagert. Das ausgefallene Produkt wird abfiltriert und aus Ethanol umkristallisiert; es werden schwach rosa gefärbte Kristalle mit einem Schmelzpunkt von 90 °C erhalten (Ausbeute: 53 %).

2. Herstellung einer Resistlösung

Durch Auflösen von 8 Masseteilen eines alternierenden Copolymeren aus Maleinsäureanhydrid und Allyltrimethylsilan und 2 Masseteilen Diazotetronsäure in 50 Masseteilen 2-Methoxy-1-propylacetat wird eine gebrauchsfertige Photoresistlösung hergestellt.

3. Bestimmung des Kontrastes, der Empfindlichkeit und des Dunkelabtrags

Auf ein Substrat wird durch Aufschleudern der nach Beispiel 2 hergestellten Resistlösung und anschließende Trocknung bei 110 °C auf einer Hotplate (Dauer: 60 s) eine 1 µm dicke Resistschicht aufgebracht. Diese Schicht wird durch eine Graukeilmaske mit Licht der Wellenlänge 249,7 nm belichtet (50 $mJ/cm^2$) und anschließend 75 s in einem handelsüblichen Entwickler (AZ 400K, verdünnt mit 5 Masseteilen Wasser und mit 0,7 Masseteilen Ammoniak versetzt) entwickelt und bei 110 °C 60 s auf der Hotplate getrocknet. Durch Ausmessung der Schichtdicken der einzelnen Graukeilabstufungen und deren Auftragung über einer logarithmischen Dosisskala wird ein Kontrast von -5,6 bei einer Empfindlichkeit von 22 $mJ/cm^2$ ermittelt. Der Abtrag der unbelichteten Resistbereiche beträgt unter diesen Bedingungen 4 nm.

4. Strukturierung der Resistschicht

Eine entsprechend Beispiel 3 erzeugte Resistschicht wird durch eine Maske, die Strukturen von 2 bis 0,5 µm aufweist, mit Licht der Wellenlänge 249,7 nm kontaktbelichtet (50 $mJ/cm^2$) und dann - wie bei Beispiel 3 beschrieben - entwickelt und getrocknet. Rasterelektronenmikroskopische Aufnahmen zeigen bis 0,5 µm aufgelöste Reliefstrukturen mit steilen Flanken.

**Ansprüche**

1. Lichtempfindliches Gemisch aus einem Polymeren und einer photoaktiven Komponente, **dadurch gekennzeichnet**, daß die photoaktive Komponente Diazotetronsäure oder ein Diazotetronsäurederivat folgender Struktur ist:

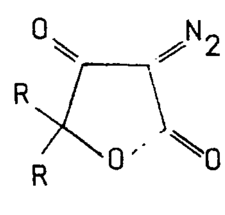

,

wobei die Reste R gleich oder verschieden sind und folgende Bedeutung haben:
R = H, Alkyl, Cycloalkyl, Aryl oder ein siliciumhaltiger Rest, oder zumindest einer der Reste R eine aliphatische oder aromatische Gruppe ist, die wenigstens eine weitere Diazotetronsäuregruppierung trägt, oder einer der Reste R für eine Einfachbindung steht, durch die die Diazotetronsäuregruppierung direkt an das Polymer gebunden ist,
oder einer der Reste R ein Alkylen-, Arylen- oder zweibindiger siliciumhaltiger Rest ist, der an das Polymer gebunden ist.

2. Lichtempfindliches Gemisch nach Anspruch 1, **dadurch gekennzeichnet,** daß es 1 bis 50 Masse-%, vorzugsweise 15 bis 25 Masse-%, an photoaktiver Komponente enthält.

3. Lichtempfindliches Gemisch nach Anspruch 1 oder 2, **dadurch gekennzeichnet,** daß das Polymere Carbonsäureanhydridgruppen aufweist.

4. Lichtempfindliches Gemisch nach Anspruch 3, **dadurch gekennzeichnet,** daß das Polymere folgende Struktur besitzt:

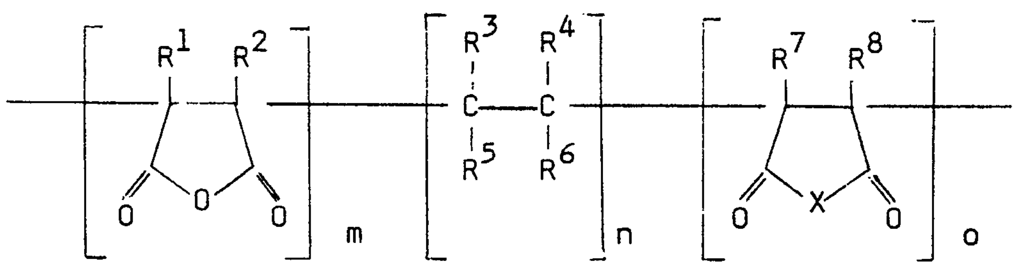

,

wobei m, n und o ganze Zahlen bedeuten und n und/oder o den Wert 0 annehmen kann und das Strukturfragment mit dem Index m einen Anteil von 10 bis 55 % an der Gesamtstruktur ausmacht, X = O, S oder NR′ ist, wobei R′ für H, Alkyl, Vinyl, Allyl, Acryl oder Aryl steht, und die Reste $R^1$ bis $R^8$ Wasserstoff, Alkyl, Aryl, Halogen, halogensubstituiertes Alkyl bzw. Aryl oder einen olefinisch ungesättigten Rest bedeuten und einer der Reste $R^3$ bis $R^6$ außerdem folgende Bedeutung haben kann:

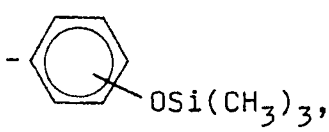

,

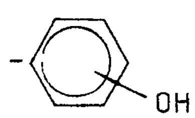

,

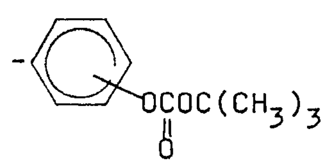

,

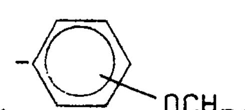

,

$-COOH$, $-COOR$, $-CH_2Si(CH_3)_3$, $-Si(CH_3)_3$ und $-Si(OCH_3)_3$ .

5. Verfahren zur Herstellung von Reliefstrukturen, **dadurch gekennzeichnet,** daß ein lichtempfindliches Gemisch nach einem der Ansprüche 1 bis 4 in Form einer Schicht oder Folie auf ein Substrat aufgebracht und mit aktinischem Licht durch eine Maske belichtet oder durch Führen eines entsprechenden Lichtstrahls bestrahlt wird, daß die belichteten bzw. bestrahlten Schicht- oder Folienteile herausgelöst oder abgezogen und die dabei erhaltenen Strukturen bei erhöhter Temperatur getrocknet und gegebenenfalls getempert werden.

6. Verfahren nach Anspruch 5, **dadurch gekennzeichnet,** daß das lichtempfindliche Gemisch als Lö sung in einem organischen Lösungsmittel auf das Substrat aufgebracht wird.

7. Verfahren nach Anspruch 5 oder 6, **dadurch gekennzeichnet,** daß ein Haftvermittler und/oder ein Benetzungsmittel verwendet wird.

Europäisches Patentamt

# EUROPÄISCHER RECHERCHENBERICHT

Nummer der Anmeldung

**EP 90 11 3581**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 735 885 (HOPF R.F., MCFARLAND M.J.)<br>* das ganze Dokument *<br>– – – | 1-7 | G 03 F 7/004 |
| A | IEEE TRANSACTIONS ON ELECTRON DEVICES. vol. ED-28, no. 11, November 1981, NEW YORK US Seiten 1300 - 1305; GRANT B.D. et al.: "Deep UV Photoresists 1. Meldrum's Diazo Sensitiver"<br>* das ganze Dokument *<br>– – – | 1 | |
| A | CHEMISCHE BERICHTE. vol. 114, no. 5, 1981, WEINHEIM DE Seiten 1958 - 1962; Schank K., Blattner R.: "5- und 6-Ring-Reduktone aus 2-Diazo-1,3-dicarbonyl-verbindungen. Eine schonende Alternative zur klassischen "verkochungsmethode""<br>* Seite 1959; Figuren a, b *<br>– – – – – | | |
| | | | **RECHERCHIERTE SACHGEBIETE (Int. Cl.5)** |
| | | | G 03 F |

Der vorliegende Recherchenbericht wurde für alle Patentansprüche erstellt

| Recherchenort | Abschlußdatum der Recherche | Prüfer |
|---|---|---|
| Den Haag | 05 November 90 | LUDI M.M.B. |

KATEGORIE DER GENANNTEN DOKUMENTE

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze

E: älteres Patentdokument, das jedoch erst am oder nach dem Anmeldedatum veröffentlicht worden ist
D: in der Anmeldung angeführtes Dokument
L: aus anderen Gründen angeführtes Dokument

&: Mitglied der gleichen Patentfamilie, übereinstimmendes Dokument